## Europäisches Patentamt
## European Patent Office
## Office européen des brevets

(19)

(11) Veröffentlichungsnummer: **0 343 375**
**B1**

(12) **EUROPÄISCHE PATENTSCHRIFT**

(45) Veröffentlichungstag der Patentschrift:
**27.12.90**

(51) Int. Cl.⁵: **H05K 3/22**

(21) Anmeldenummer: **89107071.6**

(22) Anmeldetag: **19.04.89**

(54) **Verfahren zur Reparatur von Leiterbahnunterbrechungen.**

(30) Priorität: **26.05.88 DE 3817900**

(43) Veröffentlichungstag der Anmeldung:
**29.11.89 Patentblatt 89/48**

(45) Bekanntmachung des Hinweises auf die Patenterteilung:
**27.12.90 Patentblatt 90/52**

(84) Benannte Vertragsstaaten:
**AT BE CH DE FR GB IT LI NL**

(56) Entgegenhaltungen:
**EP-A- 0 043 586**

**IBM TECHNICAL DISCLOSURE BULLETIN, Band 14, Nr. 10, März 1972, Seite 2915, New York, US; F.M. TAPPEN: "Open conductor repair for glass metal module"**
**DESIGN ENGINEERING, Band 51, Nr. 4, Oktober 1980, Seite 23, Waseca, US; "A high-speed soldering system"**

(73) Patentinhaber: **Siemens Aktiengesellschaft, Wittelsbacherplatz 2, D-8000 München 2(DE)**

(72) Erfinder: **Thorwarth, Rüdiger, Tillystrasse 4, D-8019 Glonn(DE)**
Erfinder: **Enzensberger, Siegfried, Sollner Strasse 45, D-8000 München 71(DE)**
Erfinder: **Deimann, Rolf, Grossvenediger Strasse 41, D-8000 München 80(DE)**

## Beschreibung

Die Erfindung betrifft ein Verfahren zur Reparatur von Fehlerstellen in Leiterbahnen, die mittels Überbrückung durch deckungsgleiche Formteile, die beiderseits des Fehlers gleichmäßig überlappend positioniert sind, behoben werden. Um eine elektrisch leitende und mechanisch tragende Verbindung herzustellen wird in der Regel eine Widerstandserwärmung, also eine Schweißung oder eine Hartlötung, hergestellt.

Die Weiterentwicklung von elektronischen Bauelementen und Leiterplatten geht einher mit einer Miniaturisierung der Leiterbahnen. Für die damit immer kostspieliger werdenden Leiterplatten, deren Leiterbahnen nach wie vor nicht fehlerfrei herstellbar sind, gewinnen entsprechende Reparaturverfahren zunehmend an Bedeutung. Die Forderungen an die Qualität derartiger Verfahren wächst ständig.

Bisherige Verfahren werden beispielsweise in der DE-PS 22 51 997 oder in der DE-OS 30 25 875 beschrieben. Hier werden zum einen hartlotplattierte Trägerbänder behandelt, die ausgestanzt, von einer Elektrode übernommen und auf die Fehlerstelle abgesenkt werden. Das deckungsgleiche Ausrichten geschieht durch optische Hilfsmittel. Die Nachteile der genannten Verfahren liegen zum einen in einer Vielzahl von Arbeitsschritten, wodurch ein Ausrichten und Positionieren eines Formteiles zur Reparatur einer defekten Leiterbahn erschwert wird, und zum anderen darin, daß durch die Miniaturisierung der heutigen Leiterbahnen, deren Breite mit ca. 50 bis 70 μm im Verhältnis zum Stand der Technik etwa halbiert wurde und deren Verlauf mäanderförmig ausgebildet ist, die Handhabung entsprechend kleiner Reparaturteile durch solche Verfahren nicht möglich ist.

Der Erfindung liegt die Aufgabe zugrunde, ein Verfahren zur Reparatur von Leiterbahnenunterbrechungen durch Überbrückung mittels deckungsgleicher Formteile zur Verfügung zu stellen, mit dem in wenigen Arbeitsschritten ein Formteil deckungsgleich zur Leiterbahnunterbrechung und deren Umgebung ausgerichtet und mit der Leiterbahn mechanisch und elektrisch verbunden werden kann.

Die Lösung dieser Aufgabe wird durch den kennzeichnenden Teil des Anspruches 1 wiedergegeben.

Der Erfindung liegt die Erkenntnis zugrunde, daß der Vergleich zwischen Formteil und Leiterbahn zur Feststellung der Deckungsgleichheit und die Positionierung des Formteiles auf der Leiterbahn an der Stelle der Unterbrechung zur Einsparung von Arbeitsschritten am gleichen Ort geschehen muß. Hierzu wird ein Verband von einer Vielzahl von Formteilen, ein Formteil-Nutzen, verwendet, der nach dem Aufbringen einer Isolierfolie mit einem Arbeitsfenster auf der Leiterbahn derart über der Leiterbahnunterbrechung positioniert wird, daß durch Verfahren dieses Formteil-Nutzens relativ zur Leiterbahn bei gleichzeitiger Beobachtung durch eine Optik die Deckungsgleichheit zwischen Formteil und Leiterbahn festgestellt werden kann. Das Absenken des Formteiles mittels des Formteil-Nutzes auf die Leiterbahn kann ohne Zwischenschritte direkt geschehen. Der in Anschluß daran nötige Verbindungsvorgang durch Widerstandserwärmung und das Abtrennen des einen ausgewählten Formteiles aus dem Formteil-Nutzen geschehen durch jeweils ein Mehrfachelektrodensystem.

Eine vorteilhafte Ausgestaltung der Erfindung sieht vor, daß innerhalb eines Formteil-Nutzen mehrere verschiedene Formteile entsprechend der auftretenden Leiterbahnkonfigurationen auf einer Leiterplatte enthalten sind. Dies vereinfacht ganz wesentlich den Vorgang des Vergleichens zwischen Formteil-Nutzen und Leiterbahn zur Auswahl eines deckungsgleichen Formteiles.

Zur Vermeidung eines paralaxen Fehlers bei der Auswahl und bei der deckungsgleichen Positionierung eines Formteiles bezüglich der Leiterbahnunterbrechung ist es vorteilhaft, diesen Vorgang senkrecht von oben zu kontrollieren.

Diese Kontrolle kann mittels eines Mikroskopes geschehen, eine besonders vorteilhafte Ausführung sieht jedoch den Einsatz einer Fernsehkamera vor. Damit verbunden sind ganz wesentliche Vereinfachungen in der Handhabung bezüglich der Steuerung des Verfahrens.

Zur einfachen und schnellen Durchführung des Verbindungsvorganges und des Trennvorganges ist der Einsatz von Elektrodensystemen, die mindestens drei Elektroden aufweisen, sehr vorteilhaft. Die Aufsetzflächen der Elektroden sind der Größe der Formteile, sowie der Größe der Arbeitsfenster innerhalb der Isolierfolie und dem Abstand der Leiterbahnen auf der Leiterplatte angepaßt und jede Elektrode ist für sich gefedert. Die Einzelelektroden eines Systems sind weiterhin gegenseitig elektrisch getrennt, wodurch keinerlei Kurzschluß über das Formteil entstehen kann.

Die Materialauswahl bezüglich der Isolierfolie hat ergeben, daß eine Folie aus Polyimid für die in Frage kommenden thermischen, elektrischen und mechanischen Belastungen am besten geeignet ist. Eine derartige Folie ist bis zu 300° C temperaturbeständig.

Zur Erzielung einer bezüglich der elektrischen und mechanischen Eigenschaften qualitativ guten Reparaturstelle ist es äußerst vorteilhaft, die thermische Belastung durch die Energieeinbringung bei der Widerstandserwärmung so gering wie möglich zu halten. Dies kann durch den Einsatz einer Kurzzeit-Energiequelle, die an die Elektrodensysteme angeschlossen ist, geschehen. Hierbei wird die Zeit der Widerstandserwärmung durch das Einbringen eines geregelten Kurzzeit-Impulses optimiert, d.h. so minimal wie möglich gehalten.

Um eine Beschädigung der äußerst kleinen Leiterbahnen zu vermeiden, werden die einzeln gefederten Elektroden mit einer maximalen Kraft von 0,6 N angedrückt.

Im folgenden wird anhand von schematischen Zeichnungen ein Ausführungsbeispiel beschrieben:

Fig. 1 zeigt die Relativlage von Leiterbahnunterbrechung 1, Arbeitsfenster 5, Formteil 2 und Elektrodensystem 8;9.

Fig. 2 zeigt die Seitenansicht während des Verbindungsvorganges mittels des Elektrodensystems 8;9.

Fig. 3 zeigt die Seitenansicht während des Trennvorganges mittels des Elektrodensystems 12;13.

Fig. 4 zeigt die Realtivlage der verschiedenen Einheiten nach dem Reparaturvorgang.

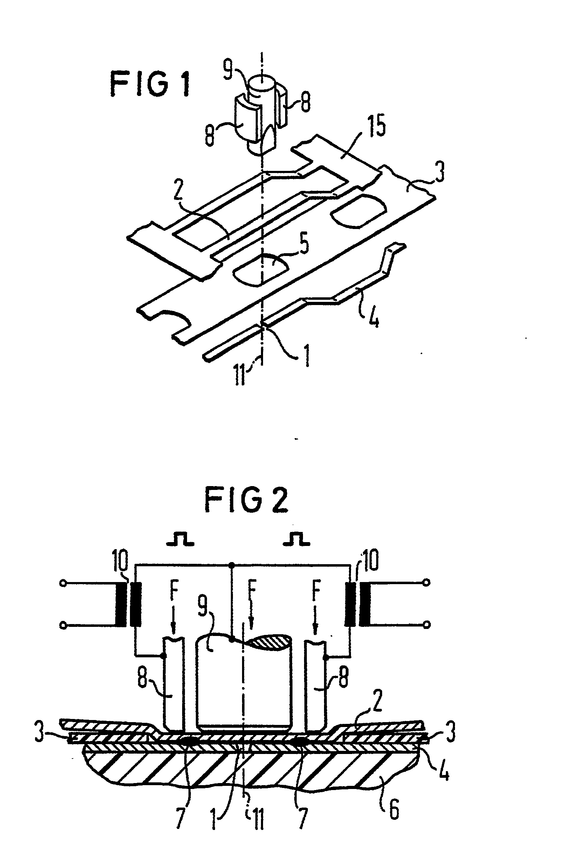

In der Fig. 1 ist entsprechend der Verfahrensschritte die Positionierung der während des Verfahrens eingesetzten Teile relativ zu einer senkrecht stehenden Achse 11 dargestellt. Über eine Leiterbahn 4, die an einer bestimmten Stelle eine Leiterbahnunterbrechung 1 aufweist, wird eine Isolierfolie 3 mit einem Arbeitsfenster 5 positioniert und wiederum über diese Isolierfolie 3 ein Formteil-Nutzen 15 mit mindestens einem Formteil 2, das deckungsgleich zur Leiterbahnunterbrechung 1 ist. Die genaue Ausrichtung der Teile ist gegeben, wenn die Leiterbahnunterbrechung 1 mittig im Arbeitsfenster 5 erscheint und das Formteil 2 deckungsgleich über der Leiterbahnunterbrechung 1 und zu dieser symmetrisch zu beiden Seiten überlappend ausgerichtet ist. Nach dem Absenken der Isolierfolie 3 und dem Formteil-Nutzen 15 mit dem Formteil 2 auf die Leiterbahn 4 kann der Verbindungsvorgang zwischen Formteil 2 und Leiterbahn 4 mittels des Elektronensystemes 8;9 vorgenommen werden. An dieser Stelle ist zu bemerken, daß dieses Verfahren einen ganz spezifischen Vorteil durch die Halterung des Formteiles 2 innerhalb des Formteil-Nutzens erbringt, in dem zwischen dem Vorgang des Ausrichtens und Absenkens und dem anschließenden Verbinden mittels Widerstandserwärmung kein Verrutschen einzelner Teile mehr möglich ist. Der wesentliche Unterschied zu bisherigen Verfahren besteht darin, daß der Vorgang des Heraustrennens des entsprechenden Formteiles 2 aus dem Formteil-Nutzen 15 erst nach dem Verbindungsvorgang geschieht.

Dieser Verbindungsvorgang wird durch die Anordnung der einzelnen Teile in der Fig. 2 dargestellt. Das Elektrodensystem, in diesem Fall ein Schweißkopf mit drei Elektroden 8;9 wird zentral entsprechend der Achse 11 auf dem Formteil 2 aufgesetzt. Die Lage der Isolierfolie 3 ist durch die symmetrische Lage des Arbeitsfensters 5 bezüglich der Achse 11 berücksichtigt. Der Leiterbahnträger 6 trägt die Leiterbahn 4, die die Leiterbahnunterbrechung 1 aufweist. Die linsenförmigen Verbindungszonen 7, die durch die Verbindung mittels Widerstandserwärmung entstehen sind annähernd symmetrisch zur Leiterbahnunterbrechung 1 plaziert und entstehen dort, wo sich die Zwischenräume zwischen den Außenelektroden 8 und der Innenelektrode 9 befinden. Die Innenelektrode 9 ist zylinderförmig ausgebildet und besitzt am unteren Teil seitliche Abflachungen, wie dies in der Fig. 1 angedeutet ist. Hierdurch wird der Aufsetzquerschnitt der Innenelektrode 9 entsprechend der ebenfalls in der Fig. 1 angedeuteten Form des Arbeitsfensters 5 angepaßt. Durch diese konstruktive Maßnahme wird außerdem ein Schutz der benachbarten Leiterbahnen, deren Abstände sehr gering sein können, gewährleistet. Die elektrische Versorgung des Elektrodensystems 8;9 geschieht durch zwei Kurzzeit-Energiequellen 10, die in der Fig. 2 in Form von Transformatoren angedeutet sind. Hierdurch werden kurze Impulse, im Idealfall Senkrechtimpulse geliefert, deren Stromstärke bei beispielsweise 50 A mit einer Spannung von 1 V und einer Impulsdauer von 5 ms liegt. Es kann wahlweise entsprechend eine Hartlötung oder eine Verschweißung durchgeführt werden. Die in der Figur angedeutete Kraft F, die jeweils durch eine Feder erzeugt wird, beträgt im Fall der Innenelektrode 9 maximal 0,6 N. Die Kraft an einer Außenelektrode 8 liegt etwa bei einem Drittel oder bei der Hälfte der Kraft, die auf die Innenelektrode 9 wirkt. Nach der Durchführung des Verbindungsvorganges wird das Elektrodensystem 8;9 entfernt.

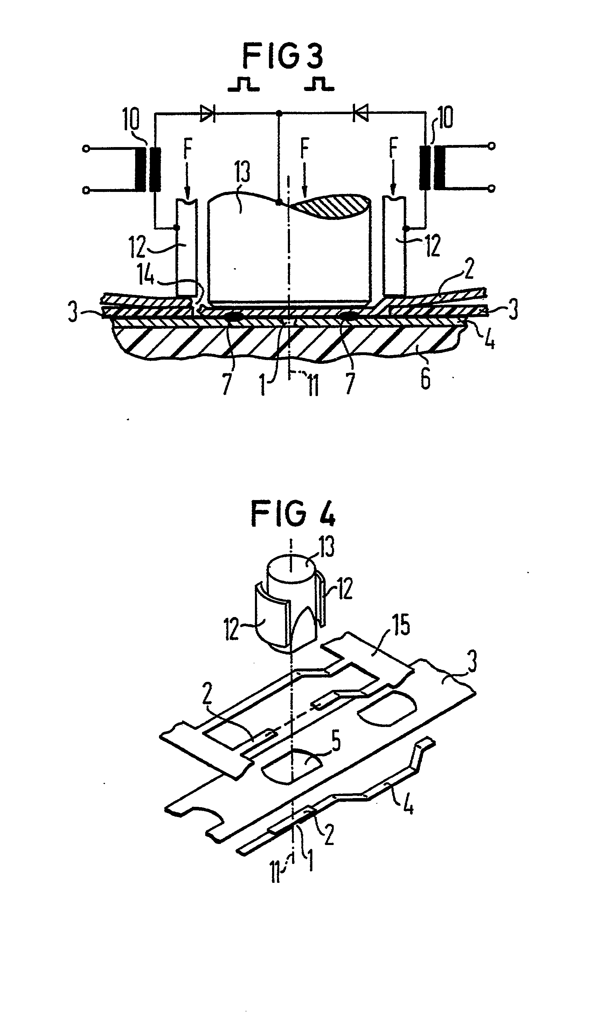

In der Fig. 3 ist bezüglich des Leiterbahnträgers 6, der Leiterbahn 4, der Isolierfolie 3 und des Formteiles 2 der gleiche Aufbau wie in der Fig. 2 vorhanden. In diesem Fall ist jedoch ein Elektrodensystem 12;13 aufgesetzt, das zum Heraustrennen desjenigen Abschnittes des Formteiles 2 aus dem vorhandenen Reperaturmaterial dient, der innerhalb des Arbeitsfensters 5 liegt und mit der Leiterbahn 4 verbunden ist. Es ist deutlich zu erkennen, daß die in diesem Fall eingesetzten Außenelektroden 12 und die Innenelektrode 13 etwas größer dimensioniert sind, als das erste Elektrodensystem 8;9. Die Kurzzeit-Energiequellen 10, die hier ebenfalls zum Einsatz kommen, sind durch zwei Dioden entkoppelt und geben wechselweise, d.h. hintereinander, einen Kurzzeitimpuls ab. Die Ausrichtung dieses zweiten Elektrodensystemes 12;13 wird ebenfalls zentral bezüglich der Achse 11 senkrecht von oben her vorgenommen. Somit läßt sich das Formteil 2 an der Kante des Arbeitsfensters 5 innerhalb der Isolierfolie 3 durch einen beschriebenen Energieimpuls aus dem Formteil-Nutzen 15 heraustrennen. Die Trennstelle 14 ist in der Fig. 3 zwischen der linken Außenelektrode 12 und der Innenelektrode 13 angedeutet. Für diesen Trennvorgang ist eine Zeit von ca. 300 µs erforderlich. Die Auslegung des Elektrodensystemes hat Auswirkungen auf die Qualität des Trennvorganges, wobei eine gleichmäßige Trennung bei geringem Energieaufwand durch eine soweit als möglich vorgenommene Minimierung des Abstandes zwischen den Außenelektroden 12 und der Innenelektrode 13 erreichbar ist.

In der Fig. 4 sind sämtliche verfahrensrelevanten Teile relativ zur Achse 11 positioniert, wobei hier die ebenfalls senkrechte Stellung des zweiten Elektrodensystems 12;13 angedeutet ist. Das Formteil 2 innerhalb des Formteil-Nutzens 15 ist zu einem bestimmten benötigten Teil entsprechend der Dimensionierung des Arbeitsfensters 5 herausgetrennt worden und mit der Leiterbahn 4 verbunden worden. Hiermit lassen sich Unterbrechungen von bis zu 400 µm Länge reparieren.

Die mechanische Steuerung zur Positionierung der einzelnen Teile ist so präzise, daß die Koordinaten beispielsweise der Achse 11 genau angesteuert und die Teile entsprechend ausgerichtet werden können. Die Überwachung des Verfahrens erfolgt mittels einer Optik, wobei der Einsatz eines Mikroskopes insofern von Nachteil ist, als der freie Arbeitsraum zwischen Objektiv und Objekt bei ca. 15 mm liegt. Wesentlich einfacher zu handhaben ist das Verfahren, wenn eine CCD-Kamera (Charged Coupled Device) eingesetzt wird. Die Höhe der Leiterbahn 4, die Höhe der Isolierfolie 3 und die Höhe des Formteiles 2 betragen beispielsweise jeweils 20 µm. Somit ist ein Bereich von ca. 40 µm Tiefe von der Oberfläche des Formteiles 2 bis zur Oberfläche der Leiterbahn 4 zu beobachten. Eine oben erwähnte Kamera hat eine Schärfentiefe von etwa 300 µm, erfüllt somit die optische Genauigkeit und erleichtert durch die Möglichkeit der Betrachtung des Reparaturvorganges auf einem Bildschirm ganz wesentlich die praktische Durchführung des Verfahrens.

Der Vorteil, ein beschriebenens Drei-Elektrodensystem einzusetzen liegt in der doppelten Funktion der jeweiligen Innenelektrode 9;13. Diese wird im Zusammenhang mit jeweils einer Außenelektrode 8;12 zur Herstellung jeweils einer Verbindungszone 7 oder einer Trennstelle 14 verwendet. Die entsprechenden Impulse der Kurzzeit-Energiequellen 10 werden zeitlich versetzt eingebracht. In diesem Fall werden geregelte Kurzzeit-Energiequellen verwendet, bei denen ein Soll/Ist-Wert-Vergleich für die Regelung, d.h. für eine Nachführung sorgt. Der zeitliche Versatz der Impulse zwischen einer Außenelektrode 8;12 und der Innenelektrode 9;13 ist notwendig, damit die Soll-/Istwertaufnahme eindeutig ist und keine gegenseitigen Verfälschungen vorkommen.

Der materielle Aufbau eines Formteiles 2 besteht aus einer Trägerschicht, meist aus Kupfer und einer meist durch Plattierung aufgebrachten Hartlotschicht. Das Formteil 2 wird mit einer Hartlotschicht auf die Leiterbahn 4 aufgesetzt.

## Patentansprüche

1. Verfahren zur Reparatur von Leiterbahnunterbrechungen durch Überbrückung mittels deckungsgleicher Formteile (2) und gegenseitigem Verbinden durch Widerstandserwärmung,
**dadurch gekennzeichnet,**
daß
- eine Isolierfolie (3) mit einem Arbeitsfenster (5) derart auf die unterbrochene Leiterbahn (4) plaziert wird, daß die Leiterbahnunterbrechung (1) zumindest annähernd mittig im Arbeitsfenster (5) erscheint,
- ein in einem Formteil-Nutzen (15) gehaltenes zur Leiterbahnunterbrechung deckungsgleiches Formteil (2) durch Absenken des Formteil-Nutzens (15) auf die Isolierfolie (3) und die Leiterbahn (4) abgesenkt und gehalten wird,
- mit einem ersten Elektrodensystem (8;9) das Formteil (2) innerhalb des Arbeitsfensters (5) auf die Leiterbahn (4) gedrückt und beidseitig der Leiterbahnunterbrechung (1) mit der Leiterbahn (4) mechanisch und elektrisch verbunden wird,
- mit einem zweiten Elektrodensystem (12;13) die über das Arbeitsfenster (5) der Isolierfolie (3) hinausstehenden Teile des Formteiles (2) am Rand des Arbeitsfensters (5) mittels Widerstandserwärmung abgetrennt werden.
2. Verfahren nach Anspruch 1,
**dadurch gekennzeichnet,**
daß ein Formteil (2) aus verschiedenen Formteil-Nutzen ausgewählt wird, wobei die Formteil-Nutzen (15) mehrere verschiedenartige Formteile (2) entsprechend der auftretenden Leiterbahnkonfigurationen auf einer Leiterplatte enthalten.
3. Verfahren nach einem der vorhergehenden Ansprüche,
**dadurch gekennzeichnet,**
daß die Auswahl und deckungsgleiche Positionierung eines Formteiles (2) bezüglich der Leiterbahnunterbrechung (1) jeweils senkrecht von oben kontrolliert wird.
4. Verfahren nach einem der vorhergehenden Ansprüche,
**dadurch gekennzeichnet,**
daß zur Auswahl und deckungsgleichen Positionierung eines Formteiles (2) bezüglich der Leiterbahnunterbrechung (1) eine Fernsehkamera verwendet wird.
5. Verfahren nach einem der vorhergehenden Ansprüche,
**dadurch gekennzeichnet,**
daß als Elektrodensysteme Schweißköpfe mit mindestens drei Elektroden (8;9;12;13) eingesetzt werden, wobei jede Elektrode für sich gefedert ist und die Elektroden gegenseitig elektrisch getrennt sind.
6. Verfahren nach einem der vorhergehenden Ansprüche,
**dadurch gekennzeichnet,**
daß eine Isolierfolie (3) aus Polyimid verwendet wird.
7. Verfahren nach einem der vorhergehenden Ansprüche,
**dadurch gekennzeichnet,**
daß die Energieversorgung der Elektrodensysteme (8;9;12;13) mittels Kurzzeit-Energiequellen (10) geschieht.
8. Verfahren nach einem der vorhergehenden Ansprüche,
**dadurch gekennzeichnet,**
daß die Andurckkräfte der Elektroden (8;9;12;13) maximal 0,6 N betragen.

## Claims

1. Method for repairing conductor track interruptions by bridging using congruent shaped parts (2) and joining together by resistance heating, characterized in that
- an insulating film (3) having a working window (5) is placed on the interrupted conductor track (4) in such a way that the conductor track interruption (1) appears at least approximately in the centre of the working window (5),
- a shaped part (2) which is congruent with the conductor track interruption and is held in a shaped part panel (15) is lowered and held by lowering the shaped part panel (15) onto the insulating film (3) and the conductor track (4),
- with a first electrode system (8; ) the shaped part (2) is pressed within the working window (5) onto the conductor track (4) and is mechanically and electrically connected to the conductor track (4) on either side of the conductor track interruption (1), and

— with a second electrode system (12; 13) the parts of the shaped part (2) projecting beyond the working window (5) of the insulating film (3) are severed at the edge of the working window (5) by means of resistance heating.

2. Method according to Claim 1, characterized in that a shaped part (2) is selected from various shaped part panels, the shaped parr panels (15) containing a plurality of various shaped parts (2) in accordance with the conductor track configuration occurring on a printed circuit board.

3. Method according to one of the preceding claims, characterized in that the selection and congruent positioning of a shaped part (2) with respect to the conductor track interruption (1) is in each case monitored vertically from above.

4. Method according to one of the preceding claims, characterized in that a television camera is used for the selection and congruent positioning of a shaped part (2) with respect to the conductor track interruption (1).

5. Method according to one of the preceding claims, characterized in that welding heads with at least three electrodes (8; 9; 12; 13) are used as electrode systems, each electrode being separately sprung and the electrodes being electrically isolated from one another.

6. Method according to one of the preceding claims, characterized in that an insulating film (3) made of polyimide is used.

7. Method according to one of the preceding claims, characterized in that the electrode systems (8; 9; 12; 13) are supplied with energy by means of short-term energy sources (10).

8. Method according to one of the preceding claims, characterized in that the pressure forces of the electrodes (8; 9; 12; 13) are a maximum of 0.6 N.

## Revendications

1. Procédé pour réparer des ruptures de voies conductrices grâce à un shuntage réalisé à l'aide de pièces de forme (2) et grâce à une liaison réciproque au moyen d'un échauffement par résistance, caractérisé par le fait que,

— on place une feuille isolante (3) munie d'une fenêtre de travail (5) sur la voie conductrice interrompue (4) de manière que l'interruption (11) de la voie conductrice apparaisse au moins approximativement d'une manière centrée dans la fenêtre de travail (5),

— on abaisse une pièce de forme (2) maintenue dans un ensemble de pièces de forme (15) et superposée de façon coïncidante à l'interruption de la voie conductrice, par abaissement de l'ensemble de pièces de forme (15) et on la fixe à la feuille isolante (3) et sur la voie conductrice (4),

— avec un premier système d'électrodes (8; 9) on repousse la pièce de forme (2) a l'intérieur de la fenêtre de travail (5) sur la voie conductrice (4) et on la fixe mécaniquement et électriquement à la voie conductrice (4), des deux côtés de l'interruption (1) de la voie conductrice,

— à l'aide d'un second système d'électrodes (12; 13), on sectionne les parties de la pièce de forme (2), qui font saillie hors de la fenêtre de travail (5) de la feuille isolante (3), au niveau du bord de la fenêtre de travail (5), à l'aide d'un chauffage par résistance.

2. Procédé suivant la revendication 1, caractérisé par le fait qu'on choisit une pièce de forme (2) possédant des flancs différents, les ensembles (15) de pièces de forme contenant plusieurs pièces de forme différentes (2) en fonction des configurations obtenues des voies conductrices sur une plaquette a circuits imprimés.

3. Procédé suivant l'une des revendications précédentes, caractérisé par le fait que l'on contrôle respectivement perpendiculairement à partir du haut le choix et le positionnement, en recouvrement coïncidant, d'une pièce de forme (2) par rapport à l'interruption (1) de la voie conductrice.

4. Procédé suivant l'une des revendications précédentes, caractérisé par le fait que pour le choix et le positionnement, en recouvrement coïncidant, d'une pièce de forme (2) par rapport à l'interruption (1) de la voie conductrice, on utilise une caméra de télévision.

5. Procédé suivant l'une des revendications précédentes, caractérisé par le fait qu'on utilise, comme systèmes d'électrodes, des têtes de soudage comportant au moins trois électrodes (8; 9; 12; 13) dont chacune est effectivement suspendue, les électrodes étant séparées électriquement les unes des autres.

6. Procédé suivant l'une des revendications précédentes, caractérisé par le fait qu'on utilise une feuille isolante (3) formée de polyimide.

7. Procédé suivant l'une des revendications précédentes, caractérisé par le fait que l'alimentation en énergie des systèmes d'électrcdes (8; 9; 12; 13) est réalisée au moyen de sources d'énergie (10) fonctionnant pendant une brève durée.

8. Procédé suivant l'une des revendications précédentes, caractérisé par le fait que les forces de compression des électrodes (8; 9; 12; 13) sont égales au maximum à 0,6 N.

# FIG 1

9

8

8

8

15

2

3

5

1

11

4

# FIG 2

10

10

F

F

F

9

8

8

2

3

3

4

7

1

11

7

6

# FIG 3

# FIG 4